# EUROPEAN PATENT SPECIFICATION

(11) **EP 3 846 227 B1**
(45) Date of publication and mention of the grant of the patent: **04.05.2022**
(21) Application number: 20216998.3
(22) Date of filing: 23.12.2020
(51) Int. Cl.: H01L 31/048

(54) **SOLAR CELL MODULES**
SOLARZELLENMODULE
MODULES DE CELLULE SOLAIRE

(30) Priority: 31.12.2019 US 201916731711; 22.12.2020 TW 109145460
(43) Date of publication of application: 07.07.2021
(73) Proprietor: Industrial Technology Research Institute, Hsinchu 31040 (TW)
(72) Inventor: KUAN, Min-Tsung, Taichung City 436 (TW); WANG, Wen-Hsien, Tainan City 722 (TW); LIU, Yi-Chun, Zhudong Township, Hsinchu County 310 (TW); HSIEH, Hsin-Hsin, Taipei City 106 (TW); LAI, Chiou-Chu, Zhubei City, Hsinchu County 302 (TW)
(74) Representative: Michalski Hüttermann & Partner Patentanwälte mbB

(56) References cited:
- EP-A1- 2 623 314
- FR-A1- 2 951 187
- US-A1- 2015 013 768
- US-B1- 6 294 724

## Description

### TECHNICAL FIELD

The present disclosure relates to a solar cell module, and more particularly to a disassemblable and recyclable solar cell module.

### BACKGROUND

With the recent growth in the popularity of solar cell modules, an increasing number of waste solar cell modules are being generated, causing problems with respect to recycling and resource reuse. In order to recover materials from used solar cell modules, the solar cell modules must first be disassembled.

In order to extend the service life of conventional silicon solar module structures, thermosetting polymers such as ethylene vinyl acetate (EVA) or polyolefin (PO) are generally used as packaging materials, to encapsulate and fix polycrystalline or monocrystalline solar cells. Once a cross-linking network occurs among molecules of the thermosetting polymers, neither the glass nor the solar cell panel can be separated by heating and melting the packaging film. As a result, an intact glass or a complete cell panel cannot be got and reused. Therefore, the current conventional method is to smash the module into pieces and burn it, to degrade the packaging film at a high enough temperature to separate the glass from the cell module. One of the difficulties encountered when disassembling conventional silicon solar cell modules is how to remove the thermosetting plastic material so that the glass and the cells can be taken out, recycled, and reused without damaging them.

At present, there are two methods for removing thermosetting plastics. One is to decompose EVA in an acid solution or an organic solvent, and the other is to heat the silicon solar cell module at a temperature of 300°C to 550°C to separate the glass plate from the solar cell module. Either method is time-consuming and labor-intensive, and will cause secondary pollution. Therefore, there is an urgent need to solve the above problems by proposing a solar cell module that is easy to be disassembled and that can pass the IEC61215 electrical verification specification to achieve high-value recycling of waste modules in the industry.

Examples of solar cell modules using thermoplastic materials as encapsulants to facilitate recycling are disclosed in patent publications FR2951187A1, US6294724B1 and EP2623314A1. An example of a solar cell module using thermosetting encapsulants is known from patent publication US2015/013768A1. Therefore, the development of a disassemblable and recyclable solar cell module with efficiency is desirable.

### SUMMARY

In accordance with one embodiment of the present disclosure, a solar cell module is provided. The solar cell module includes a first substrate; a second substrate opposite to the first substrate; a cell unit disposed between the first and the second substrates; a first thermosetting resin layer disposed between the cell unit and the first substrate; a first thermoplastic resin layer disposed between the cell unit and the first thermosetting resin layer; a second thermosetting resin layer disposed between the cell unit and the second substrate; and a second thermoplastic resin layer disposed between the cell unit and the second thermosetting resin layer.

A detailed description is given in the following embodiments with reference to the accompanying drawings.

### BRIEF DESCRIPTION OF THE DRAWINGS

FIG. 1 shows a cross-sectional view of a solar cell module in accordance with one embodiment of the present disclosure; and
FIGS. 2A to 2K show the results of disassemblable tests of solar cell modules in accordance with one embodiment of the present disclosure.

### DETAILED DESCRIPTION

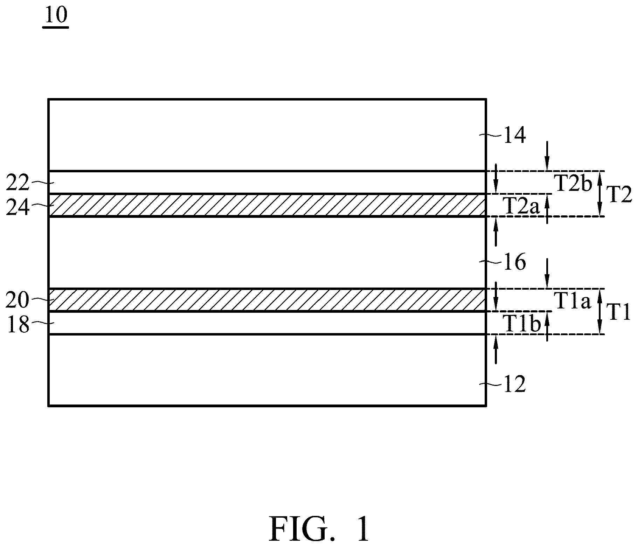

Referring to FIG. 1, in accordance with one embodiment of the present disclosure, a solar cell module 10 is provided. FIG. 1 shows a cross-sectional view of the solar cell module 10.

In FIG. 1, the solar cell module 10 includes a first substrate 12, a second substrate 14, a cell unit 16, a first thermosetting resin layer 18, a first thermoplastic resin layer 20, a second thermosetting resin layer 22 and a second thermoplastic resin layer 24. The second substrate 14 is opposite to the first substrate 12. The cell unit 16 is disposed between the first substrate 12 and the second substrate 14. The first thermosetting resin layer 18 is disposed between the cell unit 16 and the first substrate 12. The first thermoplastic resin layer 20 is disposed between the cell unit 16 and the first thermosetting resin layer 18. The second thermosetting resin layer 22 is disposed between the cell unit 16 and the second substrate 14. The second thermoplastic resin layer 24 is disposed between the cell unit 16 and the second thermosetting resin layer 22. That is, in the disclosed solar cell module 10, the two sides of the cell unit 16 are in contact with the first thermoplastic resin layer 20 and the second thermoplastic resin layer 24, respectively. One side of the first thermosetting resin layer 18 is in contact with the first thermoplastic resin layer 20, and the other side of the first thermosetting resin layer 18 is in contact with the first substrate 12. One side of the second thermosetting resin layer 22 is in contact with the second thermoplastic resin layer 24, and the other side of the second thermosetting resin layer 22 is in contact with the second substrate 14.

In some embodiments, the first substrate 12 and the second substrate 14 may include glass, polyolefin resin or polyester resin, for example, polyethylene (PE), polypropylene (PP) or polyethylene terephthalate (PET).

In some embodiments, the first thermosetting resin layer 18 and the second thermosetting resin layer 22 may include an ethylene vinyl acetate (EVA) copolymer or polyolefin (PO). In some embodiments, when the first thermosetting resin layer 18 and the second thermosetting resin layer 22 include an ethylene vinyl acetate (EVA) copolymer, the weight ratio of vinyl acetate (VA) in the ethylene vinyl acetate (EVA) copolymer is in a range from about 25wt% to about 35wt%. In some embodiments, the thickness T1b of the first thermosetting resin layer 18 and the thickness T2b of the second thermosetting resin layer 22 are in a range from about 300µm to about 2,000µm. In some embodiments, the first thermosetting resin layer 18 and the second thermosetting resin layer 22 further include additives such as a hardening initiator, an antioxidant, a crosslinking agent, or a stabilizer. In some embodiments, the weight ratio of the additives in the first thermosetting resin layer 18 and the second thermosetting resin layer 22 is in a range from about 1wt% to about 5wt%.

In some embodiments, the first thermoplastic resin layer 20 and the second thermoplastic resin layer 24 may include diblock hydrogenated styrene-based resin or triblock hydrogenated styrene-based resin. In some embodiments, the first thermoplastic resin layer 20 and the second thermoplastic resin layer 24 may include, but are not limited to, the following copolymers, for example, hydrogenated (styrene-isoprene) diblock copolymers, hydrogenated (styrene-isoprene-styrene) triblock copolymers, hydrogenated (styrene-butadiene-styrene) triblock copolymers, hydrogenated (styrene-isoprene/butadiene-styrene) triblock copolymers, hydrogenated (styrene-ethylene branched isoprene) diblock copolymers, or a combination thereof. In some embodiments, the weight ratio of the styrene block in the diblock hydrogenated styrene-based resin or the triblock hydrogenated styrene-based resin is in a range from about 10wt% to about 35wt%.

In some embodiments, the first thermoplastic resin layer 20 and the second thermoplastic resin layer 24 may include diblock acrylic-based resin or triblock acrylic-based resin. In some embodiments, the first thermoplastic resin layer 20 and the second thermoplastic resin layer 24 may include, but are not limited to, the following copolymers, for example, poly(methylmethacrylate-b-isoprene), poly(methylmethacrylate-b-butadiene), poly(methylmethacrylate-b-isoprene-b-methylmethacrylate), poly(methylmethacrylate-b-butadiene-b-methylmethacrylate), poly(methylmethacrylate-b-isoprene/butadiene-b-methylmethacrylate), poly(methylmethacrylate/acrylate/methylmethacrylate), or a combination thereof. In some embodiments, the weight ratio of the methylmethacrylate (MMA) block in the diblock acrylic-based resin or the triblock acrylic-based resin is in a range from about 20wt% to about 60wt%. In some embodiments, the weight ratio of the methylmethacrylate (MMA) block in the diblock acrylic-based resin or the triblock acrylic-based resin is in a range from about 30wt% to about 50wt%.

In some embodiments, at least one of the first thermoplastic resin layer 20 and the second thermoplastic resin layer 24 contains 0.1% to 10% of diffusion particles. That is, one of the first thermoplastic resin layer 20 and the second thermoplastic resin layer 24 contains 0.1% to 10% of the diffusion particles, or both of the first thermoplastic resin layer 20 and the second thermoplastic resin layer 24 contain 0.1% to 10% of the diffusion particles. In some embodiments, the diffusion particles may include polyacrylic resin or copolymers derived therefrom, for example, methyl polyacrylate. In some embodiments, the diffusion particles may be spherical, with a particle size ranging from about 3µm to about 60µm, and a refractive index ranging from about 1.45 to about 1.57. The disclosed diffusion particles can be uniformly dispersed in the thermoplastic resin layer. Specifically, the diffusion particles are usually added to the thermoplastic resin layer located at a light-incident surface of the module. For example, if the solar cell module 10 is a solar cell module that receives light by one side, the diffusion particles can be added to the first thermoplastic resin layer 20 or the second thermoplastic resin layer 24 located at the light-incident surface. However, if the solar cell module 10 is a solar cell module that receives light by both sides, the diffusion particles can be added to the first thermoplastic resin layer 20 and the second thermoplastic resin layer 24 located at the light-incident surfaces at the same time.

In some embodiments, at least one of the first thermoplastic resin layer 20 and the second thermoplastic resin layer 24 contains 0.1% to 5% of fluorescent material. That is, one of the first thermoplastic resin layer 20 and the second thermoplastic resin layer 24 contains 0.1% to 5% of the fluorescent material, or both of the first thermoplastic resin layer 20 and the second thermoplastic resin layer 24 contains 0.1% to 5% of the fluorescent material. In some embodiments, the fluorescent material have the material properties of absorbing ultraviolet light and converting the ultraviolet light into visible light. In some embodiments, the melting point of the fluorescent material is between about 10°C to about 130°C. The disclosed fluorescent material can be uniformly dispersed in the thermoplastic resin layer. In some embodiments, the fluorescent material may include pyrene, naphthalene-imide, perylene-imide, carbazole or anthracene. Similarly, the fluorescent material is usually added to the thermoplastic resin layer located at a light-incident surface of the module. For example, if the solar cell module 10 is a solar cell module that receives light by one side, the fluorescent material can be added to the first thermoplastic resin layer 20 or the second thermoplastic resin layer 24 located at the light-incident surface. However, if the solar cell module 10 is a solar cell module that receives light by both sides, the fluorescent material can be added to the first thermoplastic resin layer 20 and the second thermoplastic resin layer 24 located at the light-incident surfaces at the same time. The disclosed fluorescent material can absorb an external ultraviolet light and convert the absorbed ultraviolet light into a visible light that can be used by the battery. On the one hand, it can protect the packaging material from ultraviolet light. On the other hand, it can also increase the light absorption of the battery. In addition, the disclosed fluorescent material is an organic fluorescent material, which can be added to the resin layer to obtain a good dispersion effect without increasing the haze, maintaining the transparency of the packaging material.

In some embodiments, if the solar cell module 10 is a solar cell module that receives light by one side, the first thermosetting resin layer 18 or the second thermosetting resin layer 22 located at the light-incident surface of the module may contain 0.1% to 10% of the diffusion particles. In some embodiments, if the solar cell module 10 is a solar cell module that receives light by both sides, the first thermosetting resin layer 18 and the second thermosetting resin layer 22 located at the light-incident surfaces of the module may contain 0.1% to 10% of the diffusion particles at the same time. In some embodiments, the diffusion particles can be uniformly dispersed in the thermosetting resin layer.

In some embodiments, if the solar cell module 10 is a solar cell module that receives light by one side, the first thermosetting resin layer 18 or the second thermosetting resin layer 22 located at the light-incident surface of the module may contain 0.1% to 5% of the fluorescent material. In some embodiments, if the solar cell module 10 is a solar cell module that receives light by both sides, the first thermosetting resin layer 18 and the second thermosetting resin layer 22 located at the light-incident surfaces of the module may contain 0.1% to 5% of the fluorescent material at the same time. In some embodiments, the fluorescent material can be uniformly dispersed in the thermosetting resin layer.

In some embodiments, the total thickness T1 of the first thermosetting resin layer 18 and the first thermoplastic resin layer 20 is in a range from about 0.3mm to about 2.0mm. In some embodiments, the ratio of the thickness T1a of the first thermoplastic resin layer 20 and the thickness T1b of the first thermosetting resin layer 18 is in a range from about 1:0.59 to about 1:10. In some embodiments, the ratio of the thickness T1a of the first thermoplastic resin layer 20 and the thickness T1b of the first thermosetting resin layer 18 is in a range from about 1:1 to about 1:2. In some embodiments, the total thickness T2 of the second thermosetting resin layer 22 and the second thermoplastic resin layer 24 is in a range from about 0.3mm to about 2.0mm. In some embodiments, the ratio of the thickness T2a of the second thermoplastic resin layer 24 and the thickness T2b of the second thermosetting resin layer 22 is in a range from about 1:0.59 to about 1:10. In some embodiments, the ratio of the thickness T2a of the second thermoplastic resin layer 24 and the thickness T2b of the second thermosetting resin layer 22 is in a range from about 1:1 to about 1:2.

In some embodiments, the glass transition temperature of the first thermoplastic resin layer 20 and the second thermoplastic resin layer 24 is in a range from about 15°C to about -20°C. In some embodiments, the glass transition temperature of the first thermoplastic resin layer 20 and the second thermoplastic resin layer 24 is in a range from about 10°C to about -50°C. In some embodiments, the melt flow index of the first thermoplastic resin layer 20 and the second thermoplastic resin layer 24 is in a range from about 1.0 to about 31.0. In some embodiments, the melt flow index of the first thermoplastic resin layer 20 and the second thermoplastic resin layer 24 is in a range from about 1.0 to about 8.0. In some embodiments, the hardness (type A) of the first thermoplastic resin layer 20 and the second thermoplastic resin layer 24 is in a range from about 30 to about 90. In some embodiments, the hardness (type A) of the first thermoplastic resin layer 20 and the second thermoplastic resin layer 24 is in a range from about 35 to about 80.

In the present disclosure, the first thermosetting resin layer 18 and the first thermoplastic resin layer 20 form a transparent composite packaging film by, for example, bonding or co-extrusion. The second thermosetting resin layer 22 and the second thermoplastic resin layer 24 form another transparent composite packaging film by, for example, bonding or co-extrusion.

Specifically, after the disclosed solar cell module 10 is tested for weather resistance, the solar cell module 10 is further disassembled by, for example, a thermal dissociation method or a chemical dissociation method. In some embodiments, in the thermal dissociation method, the solar cell module 10 is disassembled by baking at a temperature of 450°C. In some embodiments, in the chemical dissociation method, the solar cell module 10 is disassembled by soaking in a solvent at a temperature below 40°C. In some embodiments, the solvent used in the chemical dissociation method may include hydrocarbon solvents such as toluene, 2-toluene, hexane, or cyclohexane.

In the disclosed solar cell module, the thermoplastic resin layer is added between the cell unit and the conventional thermosetting packaging material layer, and its material may include diblock or triblock hydrogenated styrene-based resin, or diblock or triblock acrylic-based resin. The structural design will enable the cell module to have characteristics of high light transmittance, low water absorption, high insulation and weather resistance, and resistance to PID, humidity, heat, and UV, so to meet the needs of cell modules. Also, the cell modules can be easily disassembled and recycled by simple thermal dissociation method or chemical dissociation method, which is not easy to cause fragments, and has the advantage of easy disassembly.

In the disclosed solar cell module, adding a specific content (for example, 0.1% to 10%) of the diffusion particles to the thermoplastic resin layer can improve the diffusion effect of light in the cell (a diffusion factor of 27 or more). The scattering characteristics can improve the light utilization rate of the battery. Even with the addition of the diffusion particles, the disclosed solar cell module still has optical properties with high light transmittance.

In the present disclosure, in addition to adding a specific content of the diffusion particles to the thermoplastic resin layer, a specific content (such as 0.1% to 5%) of the fluorescent material can also be added to the thermoplastic resin layer at the same time. In addition to the diffusion particles that can guide the reflected light of the battery back into the battery, the fluorescent material can also absorb external ultraviolet light and convert it into visible light that the battery can use, increasing the amount of light received by the battery. Therefore, when comparing the power gain of the cell module before and after packaging with the conventional cell module, the disclosed solar cell module can obtain a better power gain.

### Preparation Example 1

### Preparation of light diffusion composite film (containing diffusion particles)

100kg of triblock acrylic-based resin (KURARAY, LA2140, melt flow index: 31g/10min (190 °C, 2.16kgf)) and 3kg of diffusion particles (purchased from Soken Chemical & Engineering Co., Ltd., material: polyacrylic resin, particle size: 10µm, refractive index: 1.49) were granulated by a single screw mixer (Japan MEISEI KINZOKU MFG. CO., LTD., model: FRP-V32C). The temperature of the single screw mixer was divided into four stages, namely 145°C, 150°C, 150°C and 145°C. After a press machine (GANG LING MACHINERY CO., LTD., model: HP-50) was preheated at 150°C for 10 minutes, the sample was compressed at 150°C for 10 minutes (pressure: 100kg/cm²) to form a film as a light diffusion composite film.

### Preparation Example 2

### Preparation of light diffusion composite film (containing diffusion particles and fluorescent material)

100kg of triblock acrylic-based resin (KURARAY, LA2140, melt flow index: 31g/10min (190°C, 2.16kgf)), 3kg of diffusion particles (purchased from Soken Chemical & Engineering Co., Ltd., material: polyacrylic resin, particle size: 10µm, refractive index: 1.49) and 0.1kg of carbazole fluorescent material (purchased from NISSOKU TECHNO FINE CHEMICAL CO., LTD.) were granulated by a single screw mixer (Japan MEISEI KINZOKU MFG. CO., LTD., model: FRP-V32C). The temperature of the single screw mixer was divided into four stages, namely 145°C, 150°C, 150°C and 145°C. After a press machine (GANG LING MACHINERY CO., LTD., model: HP-50) was preheated at 150°C for 10 minutes, the sample was compressed at 150°C for 10 minutes (pressure: 100kg/cm²) to form a thermoplastic film as a light diffusion fluorescent composite film.

### Example 1

### The physical property test of the solar cell module (the thermoplastic resin layer was hydrogenated styrene-based resin with thickness of 200µm)

In this example, the physical property tests were performed on the solar cell module 10 as shown in FIG. 1. In the module structure, the materials and dimensions of related components are described below: The first substrate (back plate) 12 was a solar back plate with a thickness of about 0.31mm. The second substrate (front plate) 14 was transparent glass with a thickness of about 3.2mm. The thickness of the cell unit 16 was about 180µm. The first thermosetting resin layer 18 was an ethylene vinyl acetate (EVA) copolymer (SKC, EF2N) with a thickness of about 400µm. The first thermoplastic resin layer 20 was a hydrogenated (styrene-butadiene-styrene) triblock copolymer (SEBS) (purchased from Asahi chemical Co. Ltd. S.O.E.^{™} S1611; glass transition temperature: 9°C; melt flow index: 4g/10min (190°C; 2.16kgf)) with a thickness of about 292µm. The second thermosetting resin layer 22 was an ethylene vinyl acetate (EVA) copolymer (SKC, EF2N) with a thickness of about 400µm. The second thermoplastic resin layer 24 was a hydrogenated (styrene-butadiene-styrene) triblock copolymer (SEBS) (purchased from Asahi chemical Co. Ltd. S.O.E.^{™} S1611; glass transition temperature: 9°C; melt flow index: 4g/10min (190°C; 2.16kgf)) with a thickness of about 292µm. The total thickness T1 of the first thermosetting resin layer 18 and the first thermoplastic resin layer 20 was approximately 692±3µm. The total thickness T2 of the second thermosetting resin layer 22 and the second thermoplastic resin layer 24 was approximately 692±3µm. The following physical property tests were performed on the solar cell module 10, including, total light transmittance (%), haze (%), yellowness index (YI), water vapor transmission rate (WVTR) (g/m²-day), tensile strength at break (MPa), peeling strength (N) and volume resistance (VR) (Ω. cm), and the test results are shown in Table 1.

### Example 2

### The physical property test of the solar cell module (the thermoplastic resin layer was hydrogenated styrene-based resin with thickness of 400µm)

In this example, the physical property tests were performed on the solar cell module 10 as shown in FIG. 1. In the module structure, the materials and dimensions of related components are described below: The first substrate (back plate) 12 was a solar back plate with a thickness of about 0.31mm. The second substrate (front plate) 14 was transparent glass with a thickness of about 3.2mm. The thickness of the cell unit 16 was about 180µm. The first thermosetting resin layer 18 was an ethylene vinyl acetate (EVA) copolymer (SKC, EF2N) with a thickness of about 400µm. The first thermoplastic resin layer 20 was a hydrogenated (styrene-butadiene-styrene) triblock copolymer (SEBS) (purchased from Asahi chemical Co. Ltd. S.O.E.^{™} S1611; glass transition temperature: 9°C; melt flow index: 4g/10min (190°C; 2.16kgf)) with a thickness of about 511µm. The second thermosetting resin layer 22 was an ethylene vinyl acetate (EVA) copolymer (SKC, EF2N) with a thickness of about 400µm. The second thermoplastic resin layer 24 was a hydrogenated (styrene-butadiene-styrene) triblock copolymer (SEBS) (purchased from Asahi chemical Co. Ltd. S.O.E.^{™} S1611; glass transition temperature: 9°C; melt flow index: 4g/10min (190°C; 2.16kgf)) with a thickness of about 511µm. The total thickness T1 of the first thermosetting resin layer 18 and the first thermoplastic resin layer 20 was approximately 911±3µm. The total thickness T2 of the second thermosetting resin layer 22 and the second thermoplastic resin layer 24 was approximately 911±3µm. The following physical property tests were performed on the solar cell module 10, including, total light transmittance (%), haze (%), yellowness index (YI), water vapor transmission rate (WVTR) (g/m²-day), tensile strength at break (MPa), peeling strength (N) and volume resistance (VR) (Ω. cm), and the test results are shown in Table 1.

### Example 3

### The physical property test of the solar cell module (the thermoplastic resin layer was acrylic-based resin)

In this example, the physical property tests were performed on the solar cell module 10 as shown in FIG. 1. In the module structure, the materials and dimensions of related components are described below: The first substrate (back plate) 12 was a solar back plate with a thickness of about 0.31mm. The second substrate (front plate) 14 was transparent glass with a thickness of about 3.2mm. The thickness of the cell unit 16 was about 180µm. The first thermosetting resin layer 18 was an ethylene vinyl acetate (EVA) copolymer (SKC, EF2N) with a thickness of about 400µm. The first thermoplastic resin layer 20 was a triblock acrylic-based resin (LA2140; purchased from KURARAY Co. Ltd.; melt flow index: 31g/10min (190°C; 2.16kgf)) with a thickness of about 320µm. The second thermosetting resin layer 22 was an ethylene vinyl acetate (EVA) copolymer (SKC, EF2N) with a thickness of about 400µm. The second thermoplastic resin layer 24 was a triblock acrylic-based resin (LA2140; purchased from KURARAY Co. Ltd.; melt flow index: 31g/10min (190°C; 2.16kgf)) with a thickness of about 320µm. The total thickness T1 of the first thermosetting resin layer 18 and the first thermoplastic resin layer 20 was approximately 720µm. The total thickness T2 of the second thermosetting resin layer 22 and the second thermoplastic resin layer 24 was approximately 720µm. The following physical property tests were performed on the solar cell module 10, including, total light transmittance (%), haze (%), yellowness index (YI), water vapor transmission rate (WVTR) (g/m²-day), tensile strength at break (MPa), peeling strength (N) and volume resistance (VR) (Ω. cm), and the test results are shown in Table 1.

### Comparative Example 1

### The physical property test of the solar cell module (only EVA package)

In this comparative example, the physical property tests were performed on the specific solar cell module (the thermosetting resin layer was in contact with the cell unit and the substrate simultaneously). In the module structure, the materials and dimensions of related components are described below: The first substrate (back plate) was a solar back plate with a thickness of about 0.31mm. The second substrate (front plate) was transparent glass with a thickness of about 3.2mm. The thickness of the cell unit was about 180µm. The first thermosetting resin layer was an ethylene vinyl acetate (EVA) copolymer (SKC, EF2N) with a thickness of about 400µm. The second thermosetting resin layer was an ethylene vinyl acetate (EVA) copolymer (SKC, EF2N) with a thickness of about 400µm. The following physical property tests were performed on the solar cell module, including, total light transmittance (%), haze (%), yellowness index (YI), water vapor transmission rate (WVTR) (g/m²-day), tensile strength at break (MPa), peeling strength (N) and volume resistance (VR) (Ω. cm), and the test results are shown in Table 1.

### Comparative Example 2

### The physical property test of the solar cell module (only PO package)

In this comparative example, the physical property tests were performed on the specific solar cell module (the thermosetting resin layer was in contact with the cell unit and the substrate simultaneously). In the module structure, the materials and dimensions of related components are described below: The first substrate (back plate) was a solar back plate with a thickness of about 0.31mm. The second substrate (front plate) was transparent glass with a thickness of about 3.2mm. The thickness of the cell unit was about 180µm. The first thermosetting resin layer was polyolefin (PO) (TF4; purchased from HANGZHOU FIRST APPLIED MATERIAL CO. LTD.) with a thickness of about 400µm. The second thermosetting resin layer was polyolefin (PO) (TF4; purchased from HANGZHOU FIRST APPLIED MATERIAL CO. LTD.) with a thickness of about 400µm. The following physical property tests were performed on the solar cell module, including, total light transmittance (%), haze (%), yellowness index (YI), water vapor transmission rate (WVTR) (g/m²-day), tensile strength at break (MPa), peeling strength (N) and volume resistance (VR) (Ω. cm), and the test results are shown in Table 1.

### Comparative Example 3

### The physical property test of the solar cell module (only SEBS package)

In this comparative example, the physical property tests were performed on the specific solar cell module (the thermoplastic resin layer was in contact with the cell unit and the substrate simultaneously). In the module structure, the materials and dimensions of related components are described below: The first substrate (back plate) was a solar back plate with a thickness of about 0.31mm. The second substrate (front plate) was transparent glass with a thickness of about 3.2mm. The thickness of the cell unit was about 180µm. The first thermoplastic resin layer was a hydrogenated (styrene-butadiene-styrene) triblock copolymer (SEBS) (purchased from Asahi chemical Co. Ltd. S.O.E.^{™} S1611; glass transition temperature: 9°C; melt flow index: 4g/10min (190°C; 2.16kgf)) with a thickness of about 424µm. The second thermoplastic resin layer was a hydrogenated (styrene-butadiene-styrene) triblock copolymer (SEBS) (purchased from Asahi chemical Co. Ltd. S.O.E.^{™} S1611; glass transition temperature: 9°C; melt flow index: 4g/10min (190°C; 2.16kgf)) with a thickness of about 424µm. The following physical property tests were performed on the solar cell module, including, total light transmittance (%), haze (%), yellowness index (YI), water vapor transmission rate (WVTR) (g/m²-day), tensile strength at break (MPa), peeling strength (N) and volume resistance (VR) (Ω. cm), and the test results are shown in Table 1.

### Comparative Example 4

### The physical property test of the solar cell module (EVA and SEBS hybrid package)

In this comparative example, the physical property tests were performed on the specific solar cell module (the mixed resin layer of EVA and SEBS was in contact with the cell unit and the substrate simultaneously). In the module structure, the materials and dimensions of related components are described below: The first substrate (back plate) was a solar back plate with a thickness of about 0.31mm. The second substrate (front plate) was transparent glass with a thickness of about 3.2mm. The thickness of the cell unit was about 180µm. The first resin layer was a mixed layer of an ethylene vinyl acetate (EVA) copolymer (KA40; purchased from The Polyolefin Company) and a hydrogenated (styrene-butadiene-styrene) triblock copolymer (SEBS) (purchased from Asahi chemical Co. Ltd. S.O.E.^{™} S1611; glass transition temperature: 9°C; melt flow index: 4g/10min (190°C; 2.16kgf)) with a thickness of about 400µm. The second resin layer was a mixed layer of an ethylene vinyl acetate (EVA) copolymer (KA40; purchased from The Polyolefin Company) and a hydrogenated (styrene-butadiene-styrene) triblock copolymer (SEBS) (purchased from Asahi chemical Co. Ltd. S.O.E.^{™} S1611; glass transition temperature: 9°C; melt flow index: 4g/10min (190°C; 2.16kgf)) with a thickness of about 400µm. The following physical property tests were performed on the solar cell module, including, total light transmittance (%), haze (%), yellowness index (YI), water vapor transmission rate (WVTR) (g/m²-day), tensile strength at break (MPa), peeling strength (N) and volume resistance (VR) (Ω. cm), and the test results are shown in Table 1.

**Table 1**

| | Example 1 | Example 2 | Example 3 | Com. Example 1 | Com. Example 2 | Com. Example 3 | Com. Example 4 |
|---|---|---|---|---|---|---|---|
| Packaging materials | EVA/ SEBS | EVA/ SEBS | EVA/ Acrylic-based resin | Thermosetting EVA | Thermosetting PO | Thermoplastic SEBS | EVA and SEBS hybrid |
| Thickness (T₁) (µm) | 692±3 | 911±3 | 720 | 400 | 400 | 424 | 400 |
| Total light transmittance (%) | 87.6 | 87.4 | 87.84 | 88.4 | 88.9 | 88.3 | 54.97 |
| Haze (%) | 3.89 | 4.32 | 2.68 | 0.929 | 5.39 | 1.85 | 99.5 |
| Yellowness index | -0.01 | 0.1 | 0.02 | 0.11 | 0.14 | 0.32 | 14.65 |
| Water vapor | 5.01 | 3.61 | 2.60 | 34.00 | 3.30 | 1.55 | 10.12 |
| transmission rate (g/m²-day) | | | | | | | |
| Tensile strength at break (MPa) | 13.59 | 18.63 | 10.44 | 19 | 4.96 | 20.21 | 11.4 |
| Peeling strength (N) | 97.22 | 97.90 | 118.7 | 124.9 | 101 | 7.01 | 10.52 |
| Volume resistance (Ω. cm) | 5.63E +14 | 1.12E +15 | 4.99E +13 | 1.72E +14 | 8.65E +15 | 8.90E +15 | 2.29E +15 |
| Cell panel intact status during thermal-degradation process at 450°C | intact | intact | intact | cracks | cracks | intact | intact |

From the test results in Table 1, it can be seen that, in the disclosed solar cell modules (Examples 1-3), regardless of whether the material of the thermoplastic resin layer in the composite packaging material was hydrogenated styrene-based resin (such as SEBS) or acrylic block copolymer resin (such as acrylic block copolymer), according to the measured haze, water vapor transmission rate, and volume resistance, all of them met the requirements for the module structure to have high light transmission, low water absorption and high insulation and weather resistance.

In addition, when the thickness ratio of the thermoplastic resin layer and the thermosetting resin layer was between 1:0.59 and 1:10, the cell panel was not broken during the thermal-degradation process (Examples 1-3). When the thermal-degradation process was performed at 450°C in comparative Examples 1 and 2, where the modules have only the thermosetting packaging film, the provided solar cell modules cracked after testing. In Comparative Example 3, where the module was packaged by the thermoplastic SEBS, the subsequent electrical PID tests of the module cannot pass the standard that power loss needs to be less than 5% due to poor adhesion to glass. Comparative Example 4 also shows that when the packaging film was made from two mixed resins, its light transmittance was only 54.97%, which does not meet the standard that the light transmittance of the packaging film needs to be greater than 85%. Obviously, it cannot be made into a packaging film and to be compared with the examples. However, in the disclosed solar cell modules (Examples 1-3), regardless of whether the material of the thermoplastic resin layer in the composite packaging material was hydrogenated styrene-based resin (such as SEBS) or acrylic block copolymer resin (such as acrylic block copolymer), in the process of disassembling through the thermal dissociation method, they can be disassembled successfully without cracks or not broken, which proves that the disclosed module structures had the advantage of being easy disassembled.

### Example 4

### The physical property test of the solar cell module (the thermoplastic resin layer including triblock acrylic-based resin and diffusion particles)

In this example, the physical property tests were performed on the solar cell module 10 as shown in FIG. 1. In the module structure, the materials and dimensions of related components are described below: The first substrate (back plate) 12 was a solar back plate with a thickness of about 0.31mm. The second substrate (front plate) 14 was transparent glass with a thickness of about 3.2mm. The thickness of the cell unit 16 was about 180µm. The first thermosetting resin layer 18 was an ethylene vinyl acetate (EVA) copolymer (SKC, EF2N) with a thickness of about 400µm. The first thermoplastic resin layer 20 with a thickness of about 292µm included triblock acrylic-based resin (KURARAY, LA2140, melt flow index: 31g/10min (190°C, 2.16kgf)) and 3% of spherical diffusion particles (purchased from Soken Chemical & Engineering Co., Ltd., material: polyacrylic resin, particle size: 10µm, refractive index: 1.49). The second thermosetting resin layer 22 was an ethylene vinyl acetate (EVA) copolymer (SKC, EF2N) with a thickness of about 400µm. The second thermoplastic resin layer 24 with a thickness of about 292µm included triblock acrylic-based resin (KURARAY, LA2140, melt flow index: 31g/10min (190°C, 2.16kgf)) and 3% of spherical diffusion particles (purchased from Soken Chemical & Engineering Co., Ltd., material: polyacrylic resin, particle size: 10µm, refractive index: 1.49). The total thickness T1 of the first thermosetting resin layer 18 and the first thermoplastic resin layer 20 was approximately 692±3µm. The total thickness T2 of the second thermosetting resin layer 22 and the second thermoplastic resin layer 24 was approximately 692±3µm. The following physical property tests were performed on the solar cell module 10, including haze (%), total light transmittance (%) and diffusion factor, and the test results are shown in Table 2. In addition, the solar cell module 10 was tested for power gain (%) before and after packaging. The test results are shown in Table 3 below. The measurement method of light transmittance was ASTM D1003. The measurement method of haze was ASTM D1003. The measurement method of maximum power was IEC60891. The measurement method of short-circuit current was IEC60891. The measurement method of open-circuit voltage was IEC60891.

### Example 5

### The physical property test of the solar cell module (the thermoplastic resin layer including triblock acrylic-based resin, diffusion particles and fluorescent material)

In this example, the physical property tests were performed on the solar cell module 10 as shown in FIG. 1. In the module structure, the materials and dimensions of related components are described below: The first substrate (back plate) 12 was a solar back plate with a thickness of about 0.31mm. The second substrate (front plate) 14 was transparent glass with a thickness of about 3.2mm. The thickness of the cell unit 16 was about 180µm. The first thermosetting resin layer 18 was an ethylene vinyl acetate (EVA) copolymer (SKC, EF2N) with a thickness of about 400µm. The first thermoplastic resin layer 20 with a thickness of about 292µm included triblock acrylic-based resin (KURARAY, LA2140, melt flow index: 31g/10min (190°C, 2.16kgf)), 3% of spherical diffusion particles (purchased from Soken Chemical & Engineering Co., Ltd., material: polyacrylic resin, particle size: 10µm, refractive index: 1.49) and 0.1% of carbazole fluorescent material (purchased from NISSOKU TECHNO FINE CHEMICAL CO., LTD., melting point: 80°C). The second thermosetting resin layer 22 was an ethylene vinyl acetate (EVA) copolymer (SKC, EF2N) with a thickness of about 400µm. The second thermoplastic resin layer 24 with a thickness of about 292µm included triblock acrylic-based resin (KURARAY, LA2140, melt flow index: 31g/10min (190°C, 2.16kgf)), 3% of spherical diffusion particles (purchased from Soken Chemical & Engineering Co., Ltd., material: polyacrylic resin, particle size: 10µm, refractive index: 1.49) and 0.1% of carbazole fluorescent material (purchased from NISSOKU TECHNO FINE CHEMICAL CO., LTD., melting point: 80°C). The total thickness T1 of the first thermosetting resin layer 18 and the first thermoplastic resin layer 20 was approximately 692±3µm. The total thickness T2 of the second thermosetting resin layer 22 and the second thermoplastic resin layer 24 was approximately 692±3µm. The following physical property tests were performed on the solar cell module 10, including haze (%), total light transmittance (%) and diffusion factor, and the test results are shown in Table 2. In addition, the solar cell module 10 was tested for power gain (%) before and after packaging. The test results are shown in Table 3 below.

### Comparative Example 5

### The physical property test of the solar cell module (the thermoplastic resin layer including triblock acrylic-based resin without diffusion particles or fluorescent material)

In this comparative example, the physical property tests were performed on the solar cell module 10 as shown in FIG. 1. In the module structure, the materials and dimensions of related components are described below: The first substrate (back plate) 12 was a solar back plate with a thickness of about 0.31mm. The second substrate (front plate) 14 was transparent glass with a thickness of about 3.2mm. The thickness of the cell unit 16 was about 180µm. The first thermosetting resin layer 18 was an ethylene vinyl acetate (EVA) copolymer (SKC, EF2N) with a thickness of about 400µm. The first thermoplastic resin layer 20 with a thickness of about 292µm included triblock acrylic-based resin (KURARAY, LA2140, melt flow index: 31g/10min (190 °C, 2.16kgf)). The second thermosetting resin layer 22 was an ethylene vinyl acetate (EVA) copolymer (SKC, EF2N) with a thickness of about 400µm. The second thermoplastic resin layer 24 with a thickness of about 292µm included triblock acrylic-based resin (KURARAY, LA2140, melt flow index: 31g/10min (190°C, 2.16kgf)). The total thickness T1 of the first thermosetting resin layer 18 and the first thermoplastic resin layer 20 was approximately 692±3µm. The total thickness T2 of the second thermosetting resin layer 22 and the second thermoplastic resin layer 24 was approximately 692±3µm. The following physical property tests were performed on the solar cell module 10, including haze (%), total light transmittance (%) and diffusion factor, and the test results are shown in Table 2. In addition, the solar cell module 10 was tested for power gain (%) before and after packaging. The test results are shown in Table 3 below.

### Comparative Example 6

### The physical property test of the solar cell module (only EVA package)

In this comparative example, the physical property tests were performed on the specific solar cell module (the thermosetting resin layer was in contact with the cell unit and the substrate simultaneously). In the module structure, the materials and dimensions of related components are described below: The first substrate (back plate) was a solar back plate with a thickness of about 0.31mm. The second substrate (front plate) was transparent glass with a thickness of about 3.2mm. The thickness of the cell unit was about 180µm. The first thermosetting resin layer was an ethylene vinyl acetate (EVA) copolymer (SKC, EF2N) with a thickness of about 400µm. The second thermosetting resin layer was an ethylene vinyl acetate (EVA) copolymer (SKC, EF2N) with a thickness of about 400µm. The following physical property tests were performed on the solar cell module 10, including haze (%), total light transmittance (%) and diffusion factor, and the test results are shown in Table 2. In addition, the solar cell module 10 was tested for power gain (%) before and after packaging. The test results are shown in Table 3 below.

### Comparative Example 7

### The physical property test of the solar cell module (light guide bar and EVA package)

In this comparative example, the physical property tests were performed on the specific solar cell module (the thermosetting resin layer was in contact with the cell unit and the substrate simultaneously). In the module structure, the materials and dimensions of related components are described below: The first substrate (back plate) was a solar back plate with a thickness of about 0.31mm. The second substrate (front plate) was transparent glass with a thickness of about 3.2mm. The thickness of the cell unit (a light guide bar was pasted on the surface of the cell unit) was about 180µm. The first thermosetting resin layer was an ethylene vinyl acetate (EVA) copolymer (SKC, EF2N) with a thickness of about 400µm. The second thermosetting resin layer was an ethylene vinyl acetate (EVA) copolymer (SKC, EF2N) with a thickness of about 400µm. The following physical property tests were performed on the solar cell module 10, including haze (%), total light transmittance (%) and diffusion factor, and the test results are shown in Table 2. In addition, the solar cell module 10 was tested for power gain (%) before and after packaging. The test results are shown in Table 3 below.

### Comparative Example 8

### The physical property test of the solar cell module (EVA package and diffusion particles)

In this comparative example, the physical property tests were performed on the specific solar cell module (the thermosetting resin layer was in contact with the cell unit and the substrate simultaneously). In the module structure, the materials and dimensions of related components are described below: The first substrate (back plate) was a solar back plate with a thickness of about 0.31mm. The second substrate (front plate) was transparent glass with a thickness of about 3.2mm. The thickness of the cell unit was about 180µm. The first thermosetting resin layer with a thickness of about 400µm included an ethylene vinyl acetate (EVA) copolymer (SKC, EF2N) and 3% of spherical diffusion particles (purchased from Soken Chemical & Engineering Co., Ltd., material: polyacrylic resin, particle size: 10µm, refractive index: 1.49). The second thermosetting resin layer with a thickness of about 400µm included an ethylene vinyl acetate (EVA) copolymer (SKC, EF2N) and 3% of spherical diffusion particles (purchased from Soken Chemical & Engineering Co., Ltd., material: polyacrylic resin, particle size: 10µm, refractive index: 1.49). The following physical property tests were performed on the solar cell module 10, including haze (%), total light transmittance (%) and diffusion factor, and the test results are shown in Table 2. In addition, the solar cell module 10 was tested for power gain (%) before and after packaging. The test results are shown in Table 3 below.

**Table 2**

| | Example 4 | Example 5 | Com. Example 5 | Com. Example 6 | Com. Example 7 | Com. Example 8 |
|---|---|---|---|---|---|---|
| Module | Composite film/ cell unit | Composite film/ cell unit | Composite film/ cell unit | EVA film/ cell unit | EVA film/ cell unit (with light guide bar) | EVA film/ cell unit |
| Composition of packaging film | EVA thermosetting film/ triblock acrylic-based resin film/ diffusion particles | EVA thermosetting film/ triblock acrylic-based resin film/ diffusion particles/ fluorescent material | EVA thermosetting film/ triblock acrylic-based resin film | EVA thermosetting film | EVA thermosetting film | EVA thermosetting film/ diffusion particles |
| Haze (%) | 28.8 | 28.5 | 1.9 | 1.4 | 1.4 | 12.56 |
| Total light transmittance (%) | 94.7 | 96.0 | 96.6 | 97.6 | 97.6 | 97.04 |
| Diffusion factor | 27.3 | 27.4 | 1.9 | 1.4 | 1.4 | 12.19 |

**Table 3**

| | Example 4 | Example 5 | Com. Example 5 | Com. Example 6 | Com. Example 7 | Com. Example 8 |
|---|---|---|---|---|---|---|
| Module | Composite film/ cell unit | Composite film/ cell unit | Composite film/ cell unit | EVA film/ cell unit | EVA film/ cell unit (with light guide bar) | EVA film/ cell unit |
| Composition of packaging film | EVA thermosetting film/ triblock acrylic-based resin film/ diffusion particles | EVA thermosetting film/ triblock acrylic-based resin film/ diffusion particles/ fluorescent material | EVA thermosetting film/ triblock acrylic-based resin film | EVA thermosetting film | EVA thermosetting film | EVA thermosetting film/ diffusion particles |
| Before packaging | 12.359 | 11.933 | 12.167 | 13.035 | 12.525 | 13.024 |
| After packaging | 17.36 | 16.096 | 16.167 | 17.259 | 17.22 | 14.67 |
| Power gain (%) | 40.46 | 34.89 | 32.88 | 32.41 | 37.49 | 12.64 |

From the test results in Table 2, it can be seen that, in the disclosed solar cell modules (such as Examples 4 and 5), the diffusion particles with the specific content were added to the thermoplastic resin layer. Therefore, the diffusion effect of light in the battery can be greatly improved indeed (the diffusion factor was as high as 27 or more). Also, according to the measured haze, total light transmittance and other data, the disclosed solar cell modules still have optical characteristics of high light transmittance.

From the test results in Table 3, it can be seen that, in the disclosed solar cell modules, the diffusion particles with the specific content were added to the thermoplastic resin layer (such as Example 4). The diffusion particles and the fluorescent material with the specific contents respectively were added to the thermoplastic resin layer at the same time (such as Example 5). The diffusion particles can guide the reflected light of the battery back into the battery, and the fluorescent material can absorb external ultraviolet light and convert it into visible light that the battery can use, so that the amount of light received by the battery was increased. Therefore, when comparing the power gain of the cell modules before and after packaging with the cell modules provided by Comparative Examples 5-7, the disclosed solar cell modules can obtain a better power gain.

### Example 6

### The PID test of the solar cell modules

In Comparative Example 4, since the light transmittance of the film prepared by directly blending two materials was only 54.97% as shown in Table 1, which was not enough to meet the requirement that the light transmittance of the solar packaging film needs to be greater than 85%, it is not necessary to perform the potential induced degradation (PID) tests as the solar cell modules provided in Examples 1-3 and Comparative Examples 1-3. That is, the degree of the power loss of each cell module was tested under the conditions of a temperature of 85°C, a relative humidity of 85%, and an input voltage of 1,000V, and the test results are shown in Table 4 below.

**Table 4**

| | Packaging materials | Test time | Isc | Voc | FF | Impp | Vmpp | Pmpp | Power loss (%) |
|---|---|---|---|---|---|---|---|---|---|
| Example 1 | EVA/ SEBS | after packaging | 9.842 | 2.665 | 75.27 | 9.213 | 2.143 | 19.741 | |
| | | 96hr | 9.736 | 2.666 | 75.47 | 9.102 | 2.152 | 19.591 | 0.76% |
| | | 288hr | 9.683 | 2.665 | 75.44 | 9.038 | 2.154 | 19.465 | 1.40% |
| Example 2 | EVA/ SEBS | after packaging | 9.816 | 2.660 | 75.25 | 9.198 | 2.136 | 19.648 | |
| | | 96hr | 9.677 | 2.662 | 75.36 | 9.068 | 2.141 | 19.410 | 1.21% |
| | | 288hr | 9.640 | 2.664 | 75.60 | 9.021 | 2.152 | 19.413 | 1.20% |
| Example 3 | EVA/ Acrylic-based resin | after packaging | 2.66 | 9.64 | 2.16 | 9.16 | 77.04 | 19.756 | |
| | | 96hr | 2.67 | 9.57 | 2.16 | 9.07 | 77.01 | 19.555 | 1.02% |
| | | 288hr | 2.66 | 9.53 | 2.15 | 9.01 | 76.37 | 19.359 | 2.01% |
| Com. Example 1 | Thermosetting EVA | after packaging | 9.814 | 2.652 | 74.66 | 9.137 | 2.127 | 19.431 | |
| | | 96hr | 9.700 | 2.653 | 74.28 | 9.001 | 2.123 | 19.113 | 1.64% |
| | | 288hr | 9.695 | 2.655 | 73.99 | 8.962 | 2.125 | 19.047 | 1.98% |
| Com. Example 2 | Thermosetting PO | after packaging | 8.977 | 2.544 | 71.089 | 8.274 | 1.962 | 16.232 | |
| | | 96hr | 8.961 | 2.539 | 70.852 | 8.287 | 1.946 | 16.123 | 0.672% |
| | | 288hr | 8.961 | 2.539 | 70.135 | 8.421 | 1.895 | 15.956 | 1.700% |
| Com. Example 3 | Thermoplastic SEBS | after packaging | 8.892 | 2.528 | 70.727 | 8.217 | 1.935 | 15.897 | |
| | | 96hr | 8.857 | 2.525 | 69.715 | 8.286 | 1.881 | 15.590 | 1.933 |
| | | 288hr | 8.838 | 2.522 | 60.417 | 7.866 | 1.712 | 13.469 | 15.271 |
| Com. Example 4 | EVA and SEBS hybrid | after packaging | - | - | - | - | - | - | - |
| | | 96hr | - | - | - | - | - | - | - |
| | | 288hr | - | - | - | - | - | - | - |

From the test results in Table 4, it can be seen that, in the disclosed solar cell modules (Examples 1-3), regardless of whether the material of the thermoplastic resin layer in the composite packaging material was hydrogenated styrene-based resin (such as SEBS) or acrylic block copolymer resin (such as acrylic block copolymer), according to the measured data of the power loss (after 96hr or 288hr), it has been proved that adding the thermoplastic resin layer will not reduce the efficiency of the solar module.

### Example 7

### The humidity-heat aging test of the solar cell module

The humidity-heat aging test was performed on the solar cell module provided in Example 1. That is, the degree of the power loss of the cell module was tested under the conditions of a temperature of 85°C, a relative humidity of 85%, and a period of 1,000hr, and the test results are shown in Table 5 below.

**Table 5**

| | | | | | | | | | | |
|---|---|---|---|---|---|---|---|---|---|---|
| The humidity -heat aging test | Packaging materials | Test time | Voc _K (V) | Isc _K (A) | Vmp _K (V) | Imp _K (A) | Pmax _K (W) | FF (%) | ΔPmax (W) | Power loss (%) |
| | EVA/ SEBS | after packaging | 0.633 | 9.098 | 0.505 | 8.607 | 4.345 | 75.425 | -0.082 | 1.882 |
| | | 1,000hr | 0.631 | 8.956 | 0.504 | 8.455 | 4.263 | 75.461 | | |

From the test results in Table 5, it can be seen that, in the disclosed solar cell module (Example 1), when the material of the thermoplastic resin layer in the composite packaging material was hydrogenated styrene-based resin (such as SEBS), according to the measured data of the power loss (after 1,000hr), it has been proved that the module structure had the advantage of resisting aging caused by humidity and heat.

### Example 8

### The UV aging test of the solar cell module

The UV aging test was performed on the solar cell module provided in Example 1. That is, the degree of the power loss of the cell module was tested under the condition of a cumulative UV illumination of 15kWh/m², and the test results are shown in Table 6 below.

**Table 6**

| | | | | | | | | | | |
|---|---|---|---|---|---|---|---|---|---|---|
| The UV aging test | Packaging materials | Test time | Voc K (V) | Isc K (A) | Vmp K (V) | Imp K (A) | Pmax K (W) | FF (%) | ΔPma x (W) | Power loss (%) |
| | EVA/ SEBS | after packaging | 0.635 | 9.050 | 0.510 | 8.483 | 4.328 | 75.341 | -0.036 | 0.833 |
| | | After irradiating UV of 15kWh/m² | 0.634 | 8.982 | 0.509 | 8.424 | 4.292 | 75.320 | | |

From the test results in Table 6, it can be seen that, in the disclosed solar cell module (Example 1), when the material of the thermoplastic resin layer in the composite packaging material was hydrogenated styrene-based resin (such as SEBS), according to the measured data of the power loss (After UV irradiation of 15kWh/m²), it has been proved that the module structure had the advantage of resisting aging caused by irradiating UV.

### Example 9

### The disassemblable test of the solar cell modules

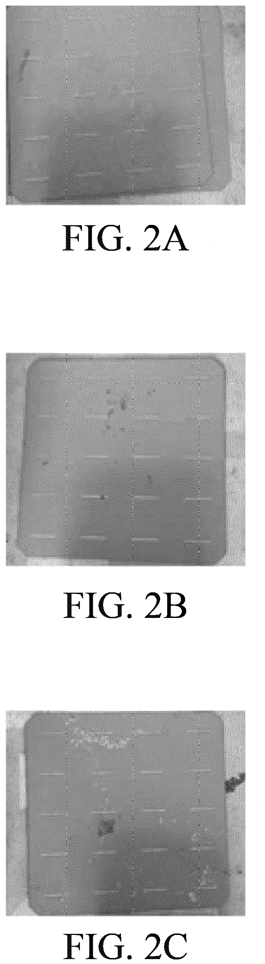

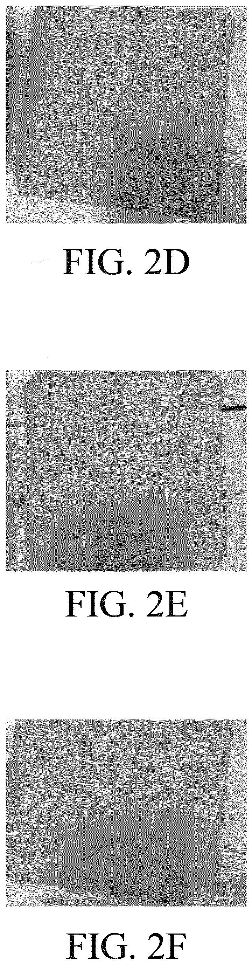

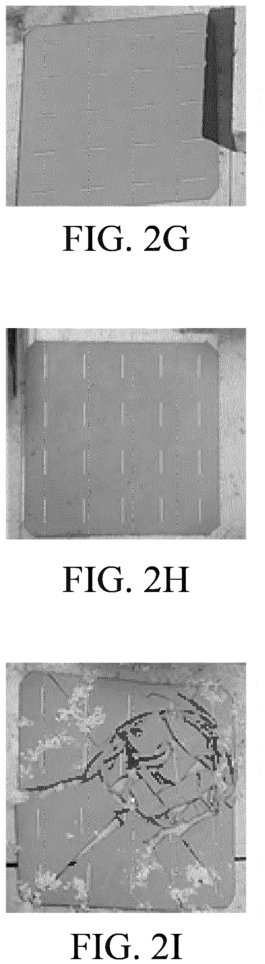

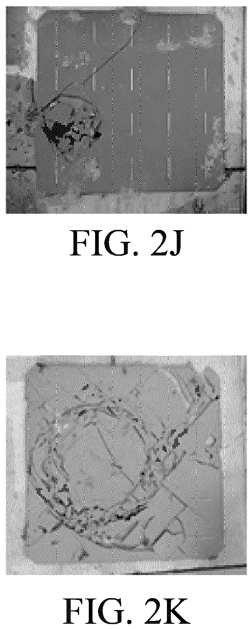

In this example, the thermal-dissociation process was performed on the solar cell modules having the thermoplastic resin layer and the thermosetting resin layer with different thicknesses and to observe whether the solar cells were broken. At a temperature of 450°C, the solar cell modules were baked to observe whether the solar cell modules could be disassembled successfully or broken pieces were caused. The following 11 groups of solar cell modules were tested. The test results are shown in FIGS. 2A to 2K. The composition materials and film thickness of the packaging films of the 11 groups of solar cell modules are as follows:
Group 1: the thickness of the thermoplastic SEBS was 220µm, the thickness of the thermosetting EVA was 1,040µm, the thickness ratio of the thermoplastic SEBS and the thermosetting EVA was 1:4.73, and the total thickness was 1,260µm.
Group 2: the thickness of the thermoplastic SEBS was 440µm, the thickness of the thermosetting EVA was 1,040µm, the thickness ratio of the thermoplastic SEBS and the thermosetting EVA was 1:2.36, and the total thickness was 1,480µm.
Group 3: the thickness of the thermoplastic SEBS was 220µm, the thickness of the thermosetting EVA was 1,560µm, the thickness ratio of the thermoplastic SEBS and the thermosetting EVA was 1:7.09, and the total thickness was 1,780µm.
Group 4: the thickness of the thermoplastic SEBS was 440µm, the thickness of the thermosetting EVA was 1,560µm, the thickness ratio of the thermoplastic SEBS and the thermosetting EVA was 1:3.55, and the total thickness was 2,000µm.
Group 5: the thickness of the thermoplastic SEBS was 880µm, the thickness of the thermosetting EVA was 520µm, the thickness ratio of the thermoplastic SEBS and the thermosetting EVA was 1:0.59, and the total thickness was 1,400µm.
Group 6: the thickness of the thermoplastic SEBS was 880µm, the thickness of the thermosetting EVA was 1,040µm, the thickness ratio of the thermoplastic SEBS and the thermosetting EVA was 1:1.18, and the total thickness was 1,920µm.
Group 7: the thickness of the thermoplastic SEBS was 40µm, the thickness of the thermosetting EVA was 400µm, the thickness ratio of the thermoplastic SEBS and the thermosetting EVA was 1:10, and the total thickness was 440µm.
Group 8: the thickness of the thermoplastic triblock acrylic was 250µm, the thickness of the thermosetting EVA was 400µm, the thickness ratio of the thermoplastic triblock acrylic and the thermosetting EVA was 1:1.6, and the total thickness was 650µm.
Group 9: the thickness of the thermoplastic SEBS was 30µm, the thickness of the thermosetting EVA was 400µm, the thickness ratio of the thermoplastic SEBS and the thermosetting EVA was 1:13.33, and the total thickness was 430µm.
Group 10: the thickness of the thermoplastic SEBS was 10µm, the thickness of the thermosetting EVA was 400µm, the thickness ratio of the thermoplastic SEBS and the thermosetting EVA was 1:40, and the total thickness was 410µm.
Group 11: the thickness of the thermosetting EVA was 400µm, and the total thickness was 400µm.

According to the test results, when the thickness ratio of the thermoplastic resin layer and the thermosetting resin layer was between 1:0.59 and 1:10, the cell panel were not broken during the thermal-degradation process (as shown in FIGS. 2A to 2H). However, when the module included only the thermosetting packaging film or the thickness ratio of the thermoplastic resin layer and the thermosetting resin layer was greater than 1:10, the cell panels were broken (as shown in FIGS. 21 to 2K).

The present disclosure provides a composite packaging film composed of a thermosetting resin layer (such as EVA) and a thermoplastic resin layer (such as SEBS). In addition to protecting the module to have a long life, when the module is disassembled, due to the thermoplastic characteristics, the molten packaging film can be separated from the glass and the complete battery at an appropriate temperature, which is beneficial to the subsequent high-value recycling.

While the invention has been described by way of example and in terms of the preferred embodiments, it should be understood that the invention is not limited to the disclosed embodiments. On the contrary, it is intended to cover various modifications and similar arrangements within the scope of the appended claims.

## Claims

1. A solar cell module (10), comprising:
a first substrate (12);
a second substrate (14) opposite to the first substrate;
a cell unit (16) disposed between the first substrate and the second substrate;
a first thermosetting resin layer (18) disposed between the cell unit and the first substrate; and
a second thermosetting resin layer (22) disposed between the cell unit and the second substrate; **characterized in that** it further comprises: a first thermoplastic resin layer (20) disposed between the cell unit and the first thermosetting resin layer; and
a second thermoplastic resin layer (24) disposed between the cell unit and the second thermosetting resin layer.

2. The solar cell module as claimed in claim 1, wherein the first thermoplastic resin layer and the second thermoplastic resin layer comprise diblock hydrogenated styrene-based resin, triblock hydrogenated styrene-based resin, diblock acrylic-based resin or triblock acrylic-based resin.

3. The solar cell module as claimed in claim 2, wherein the first thermoplastic resin layer and the second thermoplastic resin layer comprise a hydrogenated (styrene-isoprene) diblock copolymer, a hydrogenated (styrene-isoprene-styrene) triblock copolymer, a hydrogenated (styrene-butadiene-styrene) triblock copolymer, a hydrogenated (styrene-isoprene/butadiene-styrene) triblock copolymer, a hydrogenated (styrene-ethylene branched isoprene) diblock copolymer, or a combination thereof, wherein a styrene block in the diblock hydrogenated styrene-based resin or the triblock hydrogenated styrene-based resin has a weight ratio between 10wt% and 35wt%.

4. The solar cell module as claimed in claim 2, wherein the first thermoplastic resin layer and the second thermoplastic resin layer comprise poly(methylmethacrylate-b-isoprene), poly(methylmethacrylate-b-butadiene), poly(methylmethacrylate-b-isoprene-b-methylmethacrylate), poly(methylmethacrylate-b-butadiene-b-methylmethacrylate), poly(methylmethacrylate-b-isoprene/butadiene-b-methylmethacrylate), or a combination thereof, wherein a methylmethacrylate block in the diblock acrylic-based resin or the triblock acrylic-based resin has a weight ratio between 20wt% and 60wt%.

5. The solar cell module as claimed in claim 1, wherein the first thermoplastic resin layer and the first thermosetting resin layer have a thickness ratio between 1:0.59 and 1:10, and the second thermoplastic resin layer and the second thermosetting resin layer have a thickness ratio between 1:1 and 1:10.

6. The solar cell module as claimed in claim 1, wherein at least one of the first thermoplastic resin layer and the second thermoplastic resin layer contains 0.1% to 10% of diffusion particles, and the diffusion particles comprise polyacrylic resin or copolymers derived therefrom.

7. The solar cell module as claimed in claim 6, wherein the diffusion particles are spherical, with a particle size ranging from 3µm to 60µm, and a refractive index ranging from 1.45 to 1.57.

8. The solar cell module as claimed in claim 6, wherein at least one of the first thermoplastic resin layer and the second thermoplastic resin layer further contains 0.1% to 5% of fluorescent material, and the fluorescent material comprises pyrene, naphthalene-imide, perylene-imide, carbazole or anthracene.

9. The solar cell module as claimed in claim 1, wherein the first thermosetting resin layer or the second thermosetting resin layer contains 0.1% to 10% of diffusion particles.

10. The solar cell module as claimed in claim 9, wherein the first thermosetting resin layer or the second thermosetting resin layer contains 0.1% to 5% of fluorescent material.

## Patentansprüche

1. Solarzellenmodul (10) mit:
einem ersten Substrat (12);
einem dem ersten Substrat gegenüberliegenden zweiten Substrat (14);
einer zwischen dem ersten Substrat und dem zweiten Substrat angeordneten Zelleneinheit (16);
einer zwischen der Zelleneinheit und dem ersten Substrat angeordneten ersten wärmehärtenden Harzschicht (18); und
einer zwischen der Zelleneinheit und dem zweiten Substrat angeordneten zweiten wärmehärtenden Harzschicht (22);
**dadurch gekennzeichnet, dass**
das Solarzellenmodul ferner aufweist:
eine zwischen der Zelleneinheit und der ersten wärmehärtenden Harzschicht angeordnete erste thermoplastische Harzschicht (20); und
eine zwischen der Zelleneinheit und der zweiten wärmehärtenden Harzschicht angeordnete zweite thermoplastische Harzschicht (24).

2. Solarzellenmodul nach Anspruch 1, wobei die erste thermoplastische Harzschicht und die zweite thermoplastische Harzschicht ein hydriertes Diblockharz auf Styrolbasis, ein hydriertes Triblockharz auf Styrolbasis, ein Diblockharz auf Acrylbasis oder ein Triblockharz auf Acrylbasis aufweisen.

3. Solarzellenmodul nach Anspruch 2, wobei die erste thermoplastische Harzschicht und die zweite thermoplastische Harzschicht ein hydriertes (Styrol-Isopren)-Diblock-Copolymer, ein hydriertes (Styrol-Isopren-Styrol)-Triblock-Copolymer, ein hydriertes (Styrol-Butadien-Styrol)-Triblock-Copolymer, ein hydriertes (Styrol-Isopren/Butadien-Styrol)-Triblock-Copolymer, ein hydriertes (Styrol-Ethylen-(verzweigtes Isopren))-Diblock-Copolymer oder eine Kombination davon aufweisen, wobei ein Styrolblock in dem hydrierten Diblockharz auf Styrolbasis oder dem hydrierten Triblockharz auf Styrolbasis einen Gewichtsanteil zwischen 10 Gew.-% und 35 Gew.-% aufweist.

4. Solarzellenmodul nach Anspruch 2, wobei die erste thermoplastische Harzschicht und die zweite thermoplastische Harzschicht Poly(methylmethacrylat-b-isopren), Poly(methylmethacrylat-b-butadien), Poly(methylmethacrylat-b-isopren-b-methylmethacrylat), Poly(methylmethacrylat-b-butadien-b-methylmethacrylat), Poly(methylmethacrylat-b-Isopren/Butadien-b-Methylmethacrylat) oder eine Kombination davon aufweisen, wobei ein Methylmethacrylatblock in dem Diblockharz auf Acrylbasis oder dem Triblockharz auf Acrylbasis einen Gewichtsanteil zwischen 20 Gew.-% und 60 Gew.-% aufweist.

5. Solarzellenmodul nach Anspruch 1, wobei die erste thermoplastische Harzschicht und die erste wärmehärtende Harzschicht ein Dickenverhältnis zwischen 1:0,59 und 1:10 aufweisen und die zweite thermoplastische Harzschicht und die zweite wärmehärtende Harzschicht ein Dickenverhältnis zwischen 1:1 und 1:10 aufweisen.

6. Solarzellenmodul nach Anspruch 1, wobei mindestens eine unter der ersten thermoplastischen Harzschicht und der zweiten thermoplastischen Harzschicht 0,1 % bis 10% Diffusionspartikel enthält und die Diffusionspartikel Polyacrylharz oder davon gewonnene Copolymere enthalten.

7. Solarzellenmodul nach Anspruch 6, wobei die Diffusionspartikel kugelförmig sind, eine Partikelgröße im Bereich von 3 µm bis 60 µm und einen Brechungsindex im Bereich von 1,45 bis 1,57 aufweisen.

8. Solarzellenmodul nach Anspruch 6, wobei mindestens eine unter der ersten thermoplastischen Harzschicht und der zweiten thermoplastischen Harzschicht ferner 0,1% bis 5% fluoreszierendes Material enthält, und wobei das fluoreszierende Material Pyren, Naphthalinimid, Perylenimid, Carbazol oder Anthracen aufweist.

9. Solarzellenmodul nach Anspruch 1, wobei die erste wärmehärtende Harzschicht oder die zweite wärmehärtende Harzschicht 0,1% bis 10% Diffusionspartikel enthält.

10. Solarzellenmodul nach Anspruch 9, wobei die erste wärmehärtende Harzschicht oder die zweite wärmehärtende Harzschicht 0,1% bis 5% fluoreszierendes Material enthält.

## Revendications

1. Module de cellule solaire (10) comprenant :
un premier substrat (12) ;
un deuxième substrat (14) à l'opposé du premier substrat ;
une unité de cellule (16) disposée entre le premier substrat et le deuxième substrat ;
une première couche de résine thermodurcissable (18) disposée entre l'unité de cellule et le premier substrat ; et
une deuxième couche de résine thermodurcissable (22) disposée entre l'unité de cellule et le deuxième substrat,
**caractérisé en ce qu'**il comprend en outre :
une première couche de résine thermoplastique (20) disposée entre l'unité de cellule et la première couche de résine thermodurcissable ; et
une deuxième couche de résine thermoplastique (24) disposée entre l'unité de cellule et la deuxième couche de résine thermodurcissable.

2. Module de cellule solaire selon la revendication 1, dans lequel la première résine thermoplastique et la deuxième résine thermoplastique comprennent une résine bi séquencée à base de styrène hydrogéné, une résine tri-séquencée à base de styrène hydrogéné, une résine bi-séquencée à base d'acrylique ou une résine tri-séquencée à base d'acrylique.

3. Module de cellule solaire selon la revendication 2, dans lequel la première couche de résine thermoplastique et la deuxième couche de résine thermoplastique comprennent un copolymère bi-séquencé (styrène-isoprène) hydrogéné, un copolymère tri-séquencé (styrène-isoprène) hydrogéné, un copolymère tri-séquencé (styrène-butadiène - styrène) hydrogéné, un copolymère tri-séquencé (styrène-isoprène/butadiène-styrène) hydrogéné, un copolymère bi-séquencé (styrène-éthylène branché isoprène) hydrogéné ou une combinaison de ceux-ci, dans lequel une séquence styrène dans la résine bi-séquencée à base de styrène hydrogéné ou dans la résine tri-séquencée à base de styrène hydrogéné possède un ratio en poids de 10 % en poids et de 35 % en poids.

4. Module de cellule solaire selon la revendication 2, dans lequel la première couche de résine thermoplastique et la deuxième couche de résine thermoplastique comprennent du poly (méthyl méthacrylate-b-isoprène), du poly (méthyl méthacrylate-b-butadiène), du poly (méthyl méthacrylate-b-isoprène-b-méthyl méthacrylate), du poly (méthyl méthacrylate-b-butadiène-b-méthyl méthacrylate), du poly (méthyl méthacrylate-b-isoprène/butadiène-b-méthyl méthacrylate), ou une combinaison de ceux-ci, dans lequel une séquence méthyl méthacrylate dans la résine bi-séquencée à base d'acrylique ou de la résine tri-séquencée à base d'acrylique possède un ratio en poids entre 20 % en poids et 60 % en poids.

5. Module de cellule solaire selon la revendication 1, dans lequel la première couche de résine thermoplastique et la première couche de résine thermodurcis sable ont un ratio en épaisseurs entre 1 : 0,59 et 1 : 10, et la deuxième couche de résine thermoplastique et la deuxième couche de résine thermodurcis sable ont un ratio en épaisseurs entre 1 : 1 et 1 : 10.

6. Module de cellule solaire selon la revendication 1, dans lequel au moins une parmi la première couche de résine thermoplastique et la deuxième couche de résine thermoplastique contient de 0,1 % à 10 % de particules de diffusion, et les particules de diffusion comprennent une résine polyacrylique ou des copolymères en étant dérivés.

7. Module de cellule solaire selon la revendication 6, dans lequel les particules de diffusion sont sphériques avec une taille particulaire allant de 3 µm à 60 µm, et un indice de réfraction allant de 1,45 à 1,57.

8. Module de cellule solaire selon la revendication 6, dans lequel au moins une parmi la première couche de résine thermoplastique et la deuxième couche de résine thermoplastique contient en outre de 0,1 % à 5 % de matériau fluorescent, et le matériau fluorescent comprend du pyrène, un naphtalène-imide, un pérylène-imide, un carbazole ou un anthracène.

9. Module de cellule solaire selon la revendication 1, dans lequel la première couche de résine thermodurcissable ou la deuxième couche de résine thermodurcissable contient de 0,1 % à 10 % de particules de diffusion.

10. Module de cellule solaire selon la revendication 9, dans lequel la première couche de résine thermodurcissable ou la deuxième couche de résine thermodurcissable contient de 0,1 % à 5 % de matériau fluorescent.
